# EUROPÄISCHE PATENTANMELDUNG

(11) **EP 1 672 715 A1**
(43) Veröffentlichungstag der Anmeldung: **21.06.2006**
(21) Anmeldenummer: 04029928.1
(22) Anmeldetag: 17.12.2004
(51) Int. Cl.: H01L 51/40, C23C 14/24, F16K 11/056

(54) **Vorrichtung für die Beschichtung eines Substrats**

(71) Anmelder: Applied Films GmbH & Co. KG, 63755 Alzenau (DE)
(72) Erfinder: Hoffmann, Uwe, 63755 Alzenau (DE); Schreil, Manfred, 01099 Dresden (DE); Diéguez-Campo, José Manuel, 63457 Hanau (DE); Bender, Marcus, 63456 Hanau (DE)
(74) Vertreter: Schickedanz, Willi

(57) **Zusammenfassung**

Die Erfindung betrifft eine Vorrichtung für die Beschichtung eines Substrats, die eine Verdampferquelle und eine Dampfsperre zwischen der Verdampferquelle und dem Substrat aufweist. Die Dampfsperre wird auf einer Temperatur gehalten, die wenigstens gleich der Verdampfungstemperatur des zu verdampfenden Materials ist oder darüber liegt. Die Dampfsperre ist als Quarz-Ventil ausgebildet, das einen kugelförmigen Verschlussteil enthält, der mit einer bewegbaren Stange verbunden ist. In einer ersten Stellung verschließt dieser kugelförmige Verschlussteil ein Dampfführungsrohr, das mit der Verdampferquelle in Verbindung steht, und in einer zweiten Stellung schlägt der kugelförmige Verschlussteil an eine Kalotte an, die ein Quarz-Rohr abriegelt.

## Beschreibung

Die Erfindung betrifft eine Vorrichtung nach dem Oberbegriff des Patentanspruchs 1.

Neuere Entwicklungen bei der Herstellung von Flachbildschirmen für Computer oder Fernsehgeräte sind auf die so genannten organischen Leuchtdioden (OLEDs) gerichtet. Die Herstellung von OLEDs kann mittels einer OVPD-Technologie erfolgen (OVPD - Organic Vapor Phase Deposition, US 5 554 220), bei der ein Trägergasstrom bei sehr niedrigem Druck in einem beheizten Reaktor organische Materialien aufnimmt und diese als dünne Schichten auf einem Substrat niederschlägt.

Bei einem anderen Verfahren zum Beschichten eines Substrats mit einer dünnen organischen Schicht ist ein Substrathalter mit einer Heizung vorgesehen, der auf seiner Unterseite ein Substrat hält, beispielsweise Glas (EP 0 962 260 A1 = US 6 101 316). Unterhalb dieses Substrats sind zwei Verdampferquellen vorgesehen, die organisches Material verdampfen, das sich auf dem Substrat niederschlägt, wenn eine zwischen dem Substrat und dem Verdampfer befindliche Blende geöffnet ist.

Es ist auch ein elektrisch betätigtes Ventil für Glasapparaturen bekannt, das mittels eines Elektromotors geöffnet und geschlossen werden kann (DE 201 15 333 U1). Der Ventilkörper ist hierbei als Zylinder ausgebildet.

Weiterhin ist ein Ganzmetall-Ventil mit einem verschiebbaren und einem ruhenden Dichtpartner bekannt, von denen der eine Dichtpartner tellerförmig ausgebildet ist (DE 30 15 487 A1). Dieses Ventil besitzt noch einen zusätzlichen Dichtpartner, der in Funktion tritt, wenn der tellerförmig gestaltete Dichtpartner defekt ist.

Bei einem anderen bekannten Ventil ist der Ventilkörper als Kugel ausgebildet, wobei diese Kugel ein zylindrisches Rohr verschließen kann (Japan 2000120551 A).

Einen kugelförmig ausgebildeten Körper weist auch ein Ventil auf, das im Umfeld aggressiver Stoffe eingesetzt werden kann (US 3 887 162).

Ferner ist ein Ventil bekannt, das einen kugelförmigen Verschlusskörper aufweist (US 4 195 666). Dieses Ventil wird zum Steuern hochkorrosiver Fluide verwendet. Es kann in zwei verschiedenen Stellungen Fluide absperren.

Ein servogeregeltes Ventil zum Mischen zweier Fluide in einem bestimmten Verhältnis ist aus der US 3 561 484 bekannt. Dieses Ventil weist ebenfalls einen kugelförmigen Verschlusskörper auf.

Eine Verdampfervorrichtung mit einer Quelle für verdampftes organisches Material, die ein Absperrventil aufweist, ist aus der US 6 101 316 bekannt. Hierbei ist eine Evakuierungseinrichtung mit einem Behälter verbunden, der organisches Material enthält, wobei die Evakuierungseinrichtung den Behälter bei geschlossenem Ventil evakuiert.

Vorrichtungen für die Verdampfung von OLED-Materialien sind auch aus der EP 1 357 200 A1 und EP 1 401 036 A2 bekannt.

Schließlich ist eine Vorrichtung für die Beschichtung eines flächigen Substrats bekannt, die eine ortsfeste Verdampferquelle für die Verdampfung von Materialien aufweist, mit denen das Substrat beschichtet werden soll (DE 102 24 908 A1). Diese Vorrichtung weist einen Antrieb auf, der das flächige Substrat relativ zu der Verdampferquelle bewegt. Außerdem weist sie eine erste Verteilervorrichtung auf, die den von der Verdampferquelle abgegebenen Dampf linear verteilt, sowie eine zweite Verteilervorrichtung, die an ihrem einen Ende wenigstens in der Nähe der Verdampferquelle angeordnet ist und die mit ihrem anderen Ende in die erste Verteilervorrichtung mündet. Diese bekannte Vorrichtung ist auf kontinuierliches Verdampfen ausgelegt, das heißt, eine einmal begonnene Beschichtung soll über mehrere Stunden oder Tage durchgeführt werden. Bedingt durch eine gute Isolation und eine große thermische Masse ist das Regelverhalten der Verdampferquelle sehr langsam. Das Erreichen einer gewünschten Rate dauert ab Einschalten der Heizung der Verdampferquelle mehr als eine Stunde, und auch das Ausschalten der Verdampferquelle - die Zeit vom Ausschalten der Heizung bis zur Verdampfungsrate Null - dauert entsprechend lange.

Während dieser Zeit wird das sehr teure Material aus der Verdampferquelle verdampft, ohne für Beschichtungen genutzt zu werden. Ist zwischen dem Substrat und der Verdampferquelle eine Blende vorgesehen, schlägt sich das Material an dieser Blende nieder. Eine kurzzeitige Unterbrechung der Verdampfung von einigen Minuten ist nicht möglich.

Der Erfindung liegt deshalb die Aufgabe zugrunde, den Materialstrom von der Verdampferquelle zum Substrat zu unterbrechen und gleichzeitig Verdampfermaterial einzusparen.

Diese Aufgabe wird gemäß den Merkmalen des Patentanspruchs 1 gelöst.

Die Erfindung betrifft somit eine Vorrichtung für die Beschichtung eines Substrats, die eine Verdampferquelle und eine Dampfsperre zwischen der Verdampferquelle und dem Substrat aufweist. Die Dampfsperre wird auf einer Temperatur gehalten, die wenigstens gleich der Verdampfungstemperatur des zu verdampfenden Materials ist oder darüber liegt.

Die Dampfsperre ist als Quarz-Ventil ausgebildet, das einen kugelförmigen Verschlussteil enthält, der mit einer bewegbaren Stange verbunden ist. In einer ersten Stellung verschließt dieser kugelförmige Verschlussteil ein Dampfführungsrohr, das mit der Verdampferquelle in Verbindung steht, und in einer zweiten Stellung schlägt der kugelförmige Verschlussteil an eine Kalotte an, die ein Quarz-Rohr abriegelt.

Der mit der Erfindung erzielte Vorteil besteht insbesondere darin, dass die Verdampfung unterbunden wird und damit kein Materialniederschlag auf Bauteile erfolgt, die nicht das Substrat sind. Es wird also bei geschlossenem Ventil einerseits das Substrat nicht mehr beschichtet und andererseits kein Verdampfermaterial mehr verbraucht. Durch eine besondere Ausbildung der Dampfsperre als spezielles Ventil wird gewährleistet, dass in der geöffneten Stellung des Ventils einerseits der Rohrquerschnitt für den Dampfstrom freigegeben wird und andererseits der Rückraum des Ventils gegen das Eindringen des Dampfs in die Ventilführung abgedichtet wird, damit diese nicht verklebt.

Die besondere Ausbildung des Ventils ist im unabhängigen Anspruch 9 (= unechter Unteranspruch) definiert.

Ein Ausführungsbeispiel der Erfindung ist in der Zeichnung dargestellt und wird im Folgenden näher beschrieben. Es zeigen:
Fig. 1 einen Schnitt durch die wesentlichen Bauteile einer Beschichtungsanlage;
Fig. 2 eine Variante der Anlage gemäß Fig. 1 mit einem geschlossenen Ventil;
Fig. 3 die Anlage gemäß Fig. 2 mit geöffnetem Ventil.

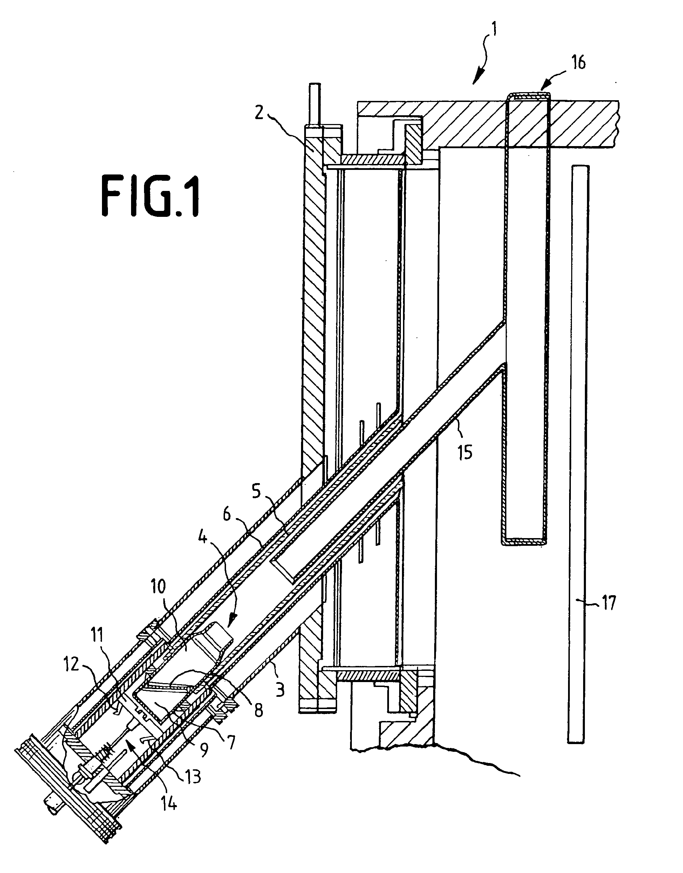

In der Fig. 1 sind die wesentlichen Bauteile einer an sich bekannten Beschichtungsanlage 1 dargestellt. Mit 2 ist hierbei eine Trägerplatte bezeichnet, an die ein rohrförmiges Gehäuse 3 angeflanscht ist, in dem sich eine Verdampferquelle 4 befindet. Diese Verdampferquelle 4 ist von einem Keramikrohr 5 umgeben, das seinerseits von einem metallischen Abschirmrohr 6 umgeben ist. Die Verdampferquelle 4 weist einen Tiegel 7 auf, der mit einer Trennwand 8 versehen ist, welche einen Leerraum 9 von einem Materialraum 10 trennt. In dem Materialraum 10 befindet sich der organische Stoff, der verdampft werden soll. Unterhalb des Tiegels 7 befindet sich eine Stütze 11 mit Abstützfedern 12, 13 und einem Wärmesensor 14. Oberhalb der Verdampferquelle 4 befindet sich ein Quarzrohr 15, das in einem Winkel von etwa 45° mit einem weiteren Quarzrohr 16 in Verbindung steht. Vor dem Quarzrohr 16 befindet sich das zu beschichtende Substrat 17. Nähere Einzelheiten über den Aufbau der Beschichtungsanlage 1 können der DE 102 24 908 A1 entnommen werden.

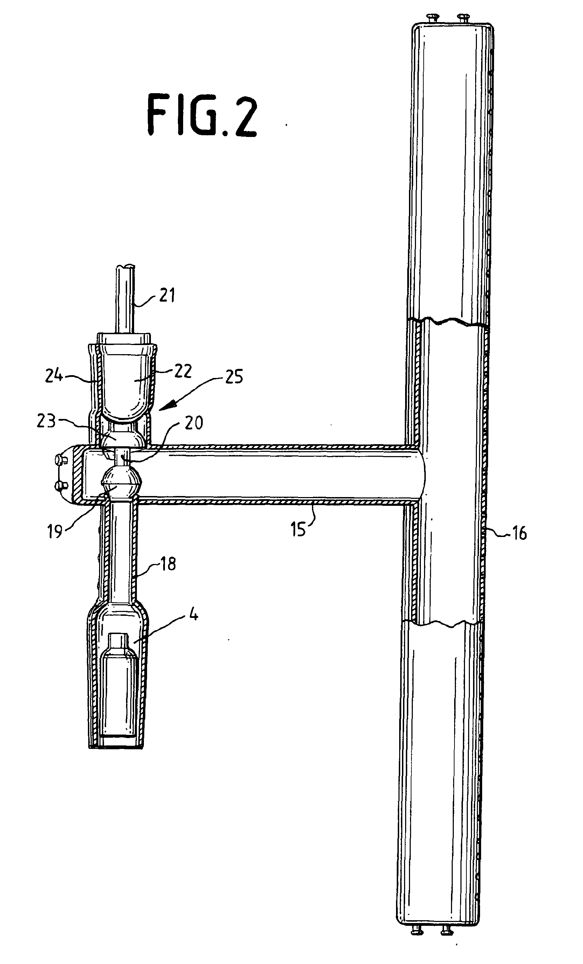

In der Fig. 2 sind die beiden Quarzrohre 15 und 16 noch einmal dargestellt, wobei das Quarzrohr 15 nunmehr senkrecht zum Quarzrohr 16 verläuft. Das Quarzrohr 15 mündet nicht nur mit seinem einen Ende in das Quarzrohr 16, sondern ist in der Nähe seines anderen Endes mit einem weiteren Quarzrohr 18 verbunden, in dem sich die Verdampferquelle 4 befindet. Das obere Ende des Quarzrohrs 18 ist bei der Darstellung der Fig. 2 mittels einer Glaskugel 19 verschlossen. Diese Glaskugel 19 ist mit einem Glasstab 20, 21 verbunden, der durch einen Stempel 22 geführt ist, an dessen unterem Ende sich eine Kalotte 23 befindet.

Im geöffneten Zustand dichtet die Kalotte 23 den durch eine Stempelführung 24 gebildeten Raum nach oben ab. Das Quarzrohr 18, die Kugel 19, der Glasstab 20 und die Kalotte 23 sind mittels nicht dargestellter Heizmittel auf eine Temperatur gebracht, die etwas über der Temperatur liegt, bei welcher das in der Verdampferquelle 4 befindliche Material verdampft.

Im geschlossenen Zustand des Ventils 25 drückt die Kugel 19 auf die Öffnung des Quarzrohrs 18, die dadurch verschlossen wird. Da der Dampf weder auf der Innenwand des Quarzrohrs 18 noch auf der Unterseite der Kugel 19 kondensieren kann, bildet sich in dem Quarzrohr 18 ein Dampfdruck aus, der ein weiteres Verdampfen des in der Verdampferquelle 4 befindlichen Materials verhindert.

Wird das Ventil geöffnet, so wird die Kugel 19 mittels des Glasstabs 20, 21 nach oben gehoben, worauf sie die Kalotte 23 verschließt.

Eine Kontaminierung des Glasstabs 20, 21, der Kalotte 23 und des Stempels 22 mit dem verdampften Material aus der Verdampferquelle 4 wird dadurch verhindert.

Die in der Fig. 2 gezeigte Anordnung der Quarzrohre 15, 16, 18 ist nicht zwingend. Das Ventil 25 könnte bei der Vorrichtung gemäß Fig. 1 auch an dem dort gezeigten Quarzrohr 15 angebracht werden.

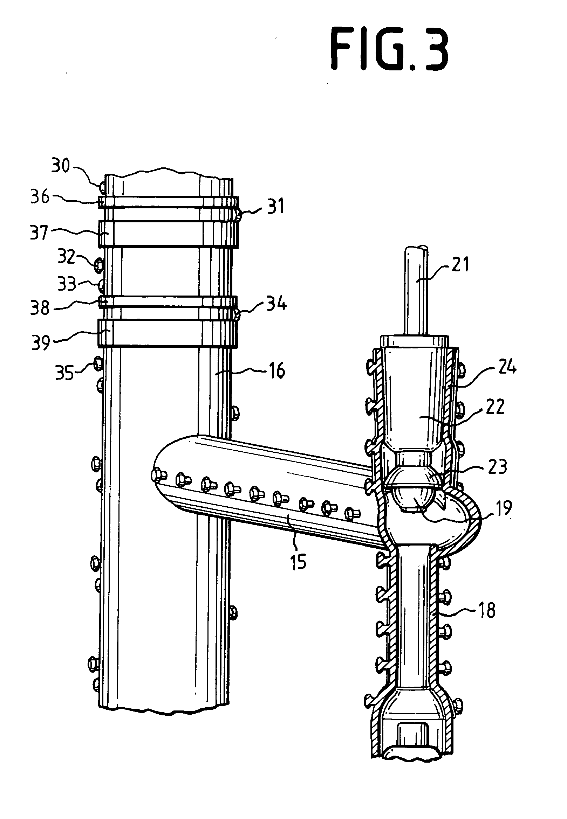

Die Fig. 3 zeigt einen Teil der in der Fig. 2 dargestellten Anordnung in perspektivischer Darstellung. Die Quarzrohre 15 und 16 sind hierbei nicht geschnitten dargestellt, während die Rohre 18 und 24 wieder geschnitten dargestellt sind.

Man erkennt hierbei an den Quarzrohren 15, 16, 18 mehrere Nippel, von denen nur die Nippel 30 bis 35 mit Bezugszahlen versehen sind. Diese Nippel dienen dazu, Heizwendeln 36 bis 39, von denen nur einige wenige dargestellt sind, auf ihrer Position zu halten.

Mit Hilfe der Heizwendeln können die Quarzrohre 15, 16, 18, 24 auf eine Temperatur gebracht werden, die der Verdampfungstemperatur des zu verdampfenden Materials entspricht. Die Kugel 19, die bei der Darstellung der Fig. 3 in der Kalotte 23 ruht, wird in ihrer Position gemäß Fig. 2 durch das erwärmte Rohr 18 aufgeheizt und in ihrer Position gemäß Fig. 3 über das Rohr 24, den Stempel 22 und die Kalotte 23 auf die vorgegebene Temperatur gebracht.

Das in den Fig. 2 und 3 dargestellte Ventil soll bis mindestens auf 500 °C beheizbar sein, damit kein verdampftes Material an seinen Wänden kondensieren kann. Es soll aus Quarzglas bestehen, das einerseits die hohen Temperaturen aushält und andererseits chemisch inert ist, sodass sich die OLED-Materialien nicht zersetzen, was im Kontakt z. B. mit Edelstahl eintreten würde.

## Patentansprüche

1. Vorrichtung für die Beschichtung eines Substrats, mit
1.1 einer Verdampferquelle (4) für die Verdampfung von Materialien, mit denen das Substrat (17) beschichtet werden soll;
1.2 einer Dampfführungsvorrichtung (15, 16, 18) von der Verdampferquelle (4) zu dem Substrat (17);
1.3 einer mechanischen Dampfsperre (19 bis 23) in der Dampfführungsvorrichtung (15, 16),
**dadurch gekennzeichnet, dass** die Dampfsperre (19 bis 23) auf oder oberhalb der Verdampfungstemperatur des zu verdampfenden Materials gehalten ist.

2. Vorrichtung nach Anspruch 1, **dadurch gekennzeichnet, dass** die Temperatur der Dampfsperre (19 bis 23) 5 % bis 50 % über der Verdampfungstemperatur des zu verdampfenden Materials liegt.

3. Vorrichtung nach Anspruch 1 oder Anspruch 2, **dadurch gekennzeichnet, dass** die Dampfführungsvorrichtung (15, 16, 18) auf der gleichen Temperatur wie die Dampfsperre (19 bis 23) gehalten ist.

4. Vorrichtung nach Anspruch 1, **dadurch gekennzeichnet, dass** die Dampfsperre (19 bis 23) aus Quarz besteht.

5. Vorrichtung nach Anspruch 1, **dadurch gekennzeichnet, dass** die Dampfführungsvorrichtung (15, 16, 18) aus Quarz besteht.

6. Vorrichtung nach einem oder mehreren der vorangegangenen Ansprüche, **dadurch gekennzeichnet, dass** die Dampfsperre (19 bis 23) ein Ventil ist.

7. Vorrichtung nach Anspruch 1, **dadurch gekennzeichnet, dass** die Dampfführungsvorrichtung (15, 16, 18) wenigstens ein Quarzrohr (18) enthält.

8. Vorrichtung nach Anspruch 1, **dadurch gekennzeichnet, dass** die Dampfführungsvorrichtung (15, 16, 18) zwei Quarzrohre (15, 18) enthält, wobei zwischen dem einen Quarz-rohr (18) und dem anderen Quarzrohr (15) die Dampfsperre (19, 20 23) vorgesehen ist.

9. Ventil, insbesondere zum Öffnen und Verschließen zweier miteinander gekoppelter Dampfführungsvorrichtungen (15, 18), **gekennzeichnet durch**
a) einen Körper (19) mit einer wenigstens zur Hälfte kugelförmigen Oberfläche;
b) eine Stange (20, 21), die mit dem Körper (19) verbunden ist;
c) eine Kalotte (23) für die Aufnahme wenigstens eines Teils des Körpers (19);
d) eine Führung (22, 24), innerhalb deren die Stange (20, 21) bewegbar ist.

10. Ventil nach Anspruch 9, **dadurch gekennzeichnet, dass** der Körper (19) eine Kugel ist.

11. Vorrichtung nach einem oder mehreren der vorangegangenen Ansprüche, **dadurch gekennzeichnet, dass** zwei miteinander verbundene rohrförmige Dampfführungsvorrichtungen (15, 18) senkrecht aufeinander stehen und die Längsachse der Stange (20, 21) mit der Längsachse wenigstens der einen Dampfführungsvorrichtung (18) zusammenfällt.

12. Vorrichtung nach Anspruch 1, **dadurch gekennzeichnet, dass** die Dampfführungsvorrichtung (15, 16, 18) mit Nippeln (30 bis 35) für die Halterung von Heizungswicklungen (36, 37, 38, 39) versehen ist.

13. Vorrichtung nach Anspruch 12, **dadurch gekennzeichnet, dass** die Nippel (30 bis 35) aus Quarzglas bestehen.

14. Vorrichtung nach Anspruch 1, **dadurch gekennzeichnet, dass** die zu verdampfenden Materialien organische Materialien für die Herstellung von Leuchtdioden sind.
